# EUROPEAN PATENT APPLICATION

(11) **EP 4 432 307 A1**
(43) Date of publication of application: **18.09.2024**
(21) Application number: 23162496.6
(22) Date of filing: 17.03.2023
(51) Int. Cl.: G21K 1/00, H01J 37/04

(54) **DEVICE FOR CONTROLLING TRAPPED IONS**

(71) Applicant: Infineon Technologies Austria AG, 9500 Villach (AT)
(72) Inventor: AUCHTER, Silke Katharina, 9500 Villach (AT); ZESAR, Alexander, 9500 Villach (AT); RÖSSLER, Clemens, 9500 Villach (AT); SCHOENHERR, Helmut Heinrich, 9500 Villach (AT)
(74) Representative: Lambsdorff & Lange Patentanwälte Partnerschaft mbB

(57) **Abstract**

A device (300) for controlling trapped ions (180) includes a substrate. A metal layer is disposed over the substrate (120). An electrode (125, M3) of an ion trap is disposed over the metal layer (135, M2), wherein the electrode is configured to trap one or more ions in a space above the electrode. An electrical insulator (130) is disposed between the metal layer and the electrode. The electrical insulator comprises an upper surface facing towards the electrode and a lower surface facing towards the metal layer. An etching rate of the electrical insulator increases along a direction pointing from the upper surface to the lower surface.

## Description

### Technical Field

This disclosure relates generally to the field of ion traps, and in particular to ion traps for quantum computing.

### Background

Trapped ions are one of the most promising candidates for use as qubits (quantum bits) in quantum computers since they can be trapped with long lifetimes in a scalable array by virtue of electromagnetic fields.

Ions can be trapped in an alternating electromagnetic field generated by an RF (radio frequency) voltage applied to surface electrodes of micro-fabricated ion traps. The more ions to be trapped in the micro-fabricated ion trap device, the smaller can be the structural width of the electrodes and, e.g., of the feed lines to the electrodes.

The ions may be addressed by lasers for cooling, state preparation and other purposes. Photoionization may generate electrical charges at dielectric surfaces in the vicinity of the ions, which may cause uncontrolled stray fields and electrical noise. To keep these charges "out of sight" of the ions as much as possible, dielectric surfaces are etched back under the electrodes. Possible charge carriers in or on the dielectrics may thus be shielded by the overhanging electrodes.

However, mechanical stress can bend the overhanging electrodes or, in the case of small electrodes, may lift them off completely. Critical forces may arise, for example, from capillary forces during or after wet chemical processing, from rinsing water during sawing, or at the customer's site from additional cleaning processes carried out. In practice, this may limit the achievable complexity and scalability of ion trap designs with respect to the required stability and robustness of the device.

### Summary

According to an aspect of the disclosure, a device for controlling trapped ions includes a substrate. A metal layer is disposed over the substrate. An electrode of an ion trap is disposed over the metal layer, wherein the electrode is configured to trap one or more ions in a space above the electrode. An electrical insulator is disposed between the metal layer and the electrode. The electrical insulator includes an upper surface facing towards the electrode and a lower surface facing towards the metal layer. An etching rate of the electrical insulator increases along a direction pointing from the upper surface to the lower surface.

According to another aspect of the disclosure, a method of manufacturing a device for controlling trapped ions includes providing a substrate. A metal layer is formed over the substrate. An electrical insulator is formed over the metal layer, wherein the electrical insulator includes a lower surface facing towards the metal layer and an upper surface facing in an opposite direction as the lower surface. An etching rate of the electrical insulator increases along a direction pointing from the upper surface to the lower surface. An electrode is formed over the electrical insulator. The electrical insulator is etched.

### Brief description of the drawings

The elements of the drawings are not necessarily to scale relative to each other. Like reference numerals designate corresponding similar parts. The features of the various illustrated examples can be combined unless they exclude each other and/or can be selectively omitted if not described to be necessarily required. Examples are depicted in the drawings and are exemplarily detailed in the description which follows.
Figure 1 is a schematic cross-sectional view of an exemplary device for controlling trapped ions.
Figure 2 is a top view of the exemplary device for controlling trapped ions shown in Figure 1.
Figure 3 is a schematic cross-sectional view of an exemplary device for controlling trapped ions having a further substrate disposed over and spaced apart from the substrate shown in Figure 1.
Figures 4A and 4B are schematic cross-sectional views of a comparative example of an electrode of an ion trap before and after back-etching a dielectric layer to produce an electrode having an overhanging edge region.
Figure 5 is a schematic cross-sectional view of a layer stack including an electrode, a metal layer and an electrical insulator in between.
Figures 6A and 6B are schematic cross-sectional views of an electrode disposed over an interface layer before and after isotropic back-etching the dielectric layer to produce an electrode having an overhanging edge region.
Figures 6C and 6D are schematic cross-sectional views of an electrode disposed over an interface layer after anisotropic back-etching the dielectric layer and after subsequently isotropic back-etching the dielectric layer to produce an electrode having an overhanging edge region.
Figures 7A to 7C are schematic cross-sectional views illustrating exemplary stages of a method of manufacturing a device for controlling trapped ions.
Figures 8A and 8B are schematic cross-sectional views of an electrode disposed over an etching rate gradient dielectric layer before and after isotropic back-etching the dielectric layer to produce an electrode having overhanging edge regions.
Figures 9A is a schematic cross-sectional partial view of an electrode disposed over an etching rate gradient dielectric layer after anisotropic etching the dielectric layer.
Figures 9B is a schematic cross-sectional partial view of the electrode of Figure 9A after isotropic back-etching the dielectric layer.
Figure 10 is a flowchart illustrating exemplary stages of a method of manufacturing a device for controlling trapped ions.

### Detailed description

The words "over" or "on" or "beneath" with regard to a part, element or material layer formed or located or disposed or arranged or placed "over" or "on" or "beneath" a surface may be used herein to mean that the part, element or material layer be located (e.g., placed, formed, arranged, deposited, etc.) "directly on" or "directly under", e.g. in direct contact with, the implied surface. The word "over" or "on" or "beneath" used with regard to a part, element or material layer formed or located or disposed or arranged or placed "over" or "on" or "beneath" a surface may, however, either be used herein to mean that the part, element or material layer be located (e.g., placed, formed, arranged, deposited, etc.) "indirectly on" or "indirectly under" the implied surface, with one or more additional parts, elements or layers being arranged between the implied surface and the part, element or material layer.

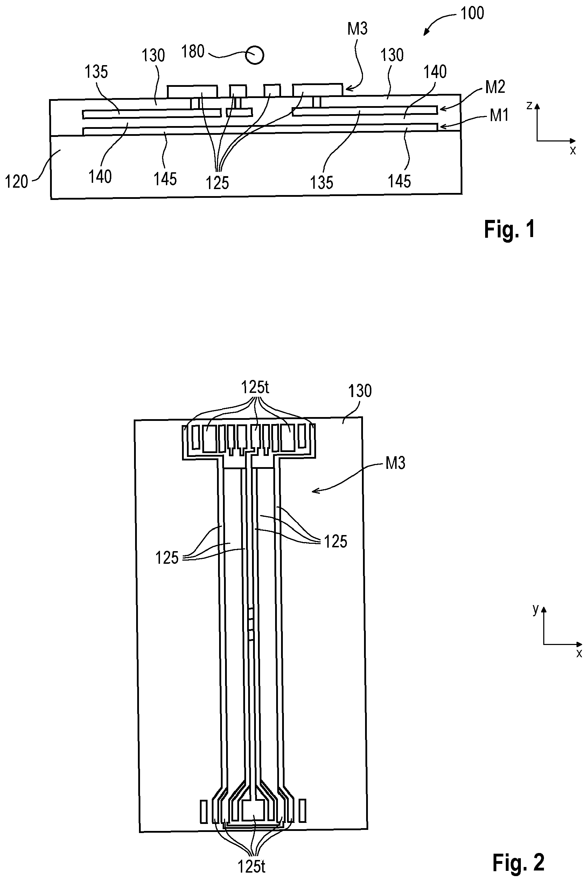

Referring to Figure 1, a device 100 for controlling trapped ions includes a substrate 120 and one or more electrodes 125 disposed over the substrate 120. The at least one electrode 125 may, e.g., be formed of a structured electrode layer M3. The device 100 further includes a metal layer 135 (also referred to as M2) disposed over the substrate 120 and an electrical insulator 130 (formed as an electrically insulating layer) disposed over the metal layer 135 (M2) and beneath the structured electrode layer M3.

The device 100 contains at least one ion trap. The electrodes 125 are part of this ion trap and configured to trap one or a plurality of ions 180 in a space above the electrodes 125 (only one ion 180 is shown in Figure 1 for ease of illustration).

The location of the ion 180 can be controlled by electrical voltage(s) applied to the electrode(s) 125 of the structured electrode layer M3. For instance, the ion 180 can be moved in the space in one or more lateral directions (e.g., in the X-direction or in the Y-direction (see Figure 2) or in any direction lying in a plane which is normal to the Z-direction) by AC and DC voltages separately coupled to specific electrodes 125.

The structured electrode layer M3 may further include feed lines connected to the electrodes 125. Such feed lines, like any other structure of the structured electrode layer M3, may also be indicated by reference numeral 125.

The structured electrode layer M3 is an electrically conductive layer. It may include or be a metal layer, for example.

As shown in Figure 1, the device 100 for controlling trapped ions may optionally have one or multiple further metal layers disposed between the substrate 120 and the metal layer 135 (M2). For example, a (structured or non-structured) further metal layer 145 (also referred to as M1) may be disposed over the substrate 120 and separated from the metal layer 135 (M2) by a dielectric layer 140 disposed over the further metal layer 145 (M1) and beneath the metal layer 135 (M2).

The metal layer 135 (M2) may, e.g., be a structured metal layer. The structured metal layer 135 (M2) may form a metal interconnect (wiring) configured to electrically connect the electrodes 125 of the structured electrode layer M3 to external circuitry. As shown in Figure 1, the structured metal layer 135 (M2) may be electrically connected to the (separate) electrodes 125 of the structured electrode layer M3 by vias extending through the electrical insulator 130.

In other words, the structured metal layer 135 (M2) may, e.g., be structured as an electrical redistribution layer. This allows the formation of complex electrode structures and insular electrodes 125 in the structured electrode layer M3. Further, such a multilayer architecture of the device 100 for controlling trapped ions promotes scalability of the device 100.

The further metal layer 145 (M1) may, e.g., be a continuous shielding layer. In other examples, the further metal layer 145 (M1) may also be a structured metal layer used, e.g., as an additional electrical redistribution layer contributing for implementing a two-level electrode interconnect (wiring).

In other examples, the metal layer 135 (M2) may be a continuous shielding layer. In this case, the (optional) further metal layer 145 (M1) may be formed as a structured metal layer serving as a wiring layer for the electrodes 125. In this case, the continuous shielding layer M2 (metal layer 135) serves to shield the trap electrodes 125 from the wiring layer M1 (metal layer 145).

The structured electrode layer M3 and thus the electrodes 125 of the ion trap(s) may be fabricated by micro-fabrication techniques. The substrate 120 may be substantially planar. The Z-direction may represent the height dimension of the device 100. The X-direction and the Y-direction are perpendicular to each other and define a plane in the width and length direction of the device 100, which is normal to the Z-direction.

The electrode layer M3 (and thus, the electrode 125) comprises or is of an electrically conducting material such as, e.g., an AlSiCu alloy or an AlCu alloy. An exemplary AlSiCu alloy may have a chemical composition in percent by weight of 98.5 %wt of Al, 1.0 %wt of Si and 0.5 %wt of Cu, balance incidental impurities. An exemplary AlCu alloy may have a chemical composition in percent by weight of 99.5 %wt of Al and 0.5 %wt of Cu, balance incidental impurities. These materials are widely used in microfabrication technology. In other examples, the electrically conducting material may be Cu or Au or Ag, or any combination of the above-mentioned materials.

Further, the electrode layer M3 (and thus, the electrode 125) may comprise one or more layers of TiW or TiN or Pt or W or Pd or Ti. All these materials have a yield strength (stiffness) greater than the yield strength of, e.g., AlSiCu alloy or AlCu alloy or Cu or Au or Ag. Therefore, they may be used as reinforcing layers which add stiffness to the electrodes 125.

An exemplary (non-limiting) chemical composition of TiW in percent by weight is 18 to 20 %wt of Ti, the balance W and incidental impurities.

TiN has a high hardness and is known to be used as a barrier metal in microelectronics. Pt or W or Pd or Ti also have high hardness and are used for specific applications in microelectronics.

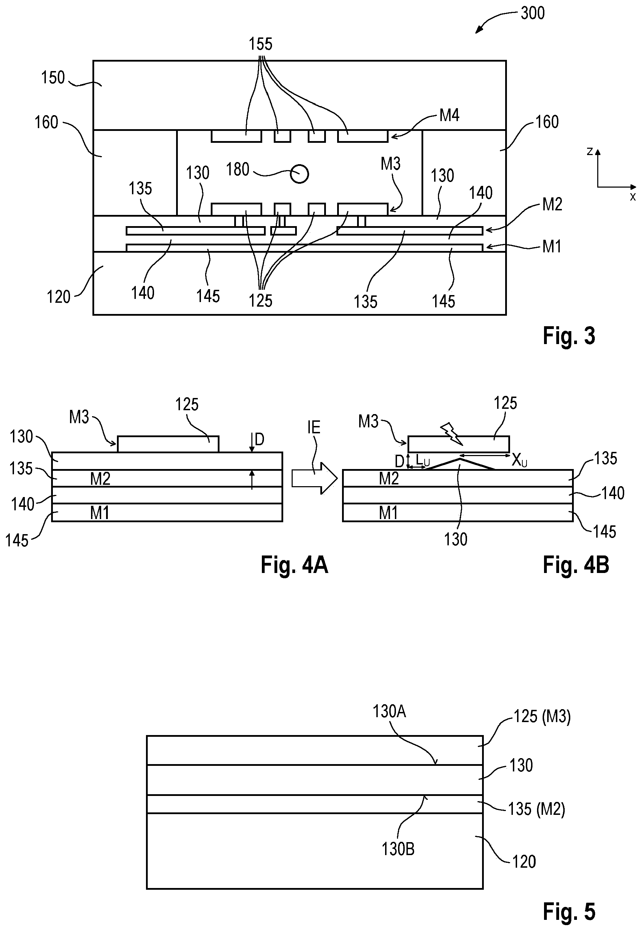

In Figure 1, the ion trap of the device 100 is exemplified to be designed as a so-called "surface-electrode" ion trap. In surface-electrode ion traps all electrodes (i.e., DC electrodes 125 and RF electrodes 125) are contained in a single plane. Such two-dimensional (2D) ion trap geometries provide for high scalability. As will be described further below, in other examples the device 100 for controlling trapped ions may use three-dimensional (3D) ion trap geometry (Figure 3).

In the examples disclosed herein the structured electrode layer M3 may include RF electrodes 125 for RF trapping and DC electrodes 125 for static electric-field trapping. An ion trap disclosed herein can trap many ions 180 that may be individually addressable and movable by appropriately controlling the potentials of the electrodes 125 of the ion trap.

Figure 2 is a schematic top view of an exemplary, simplified electrode structure formed in the structured electrode layer M3. Some of the electrodes 125 are formed as stripe electrodes, while other electrodes 125 may be formed as insular electrodes of small lateral dimensions, for example. Many different electrode layouts are known in the art and could be used in the example devices disclosed herein.

Figure 2 further illustrates optional terminal lands 125t of the structured electrode layer M3 available for electrically connecting the micro-fabricated electrodes 125 via connectors (not shown, e.g., wire bonds) to external circuitry (not shown). Other designs of electrical connections of the electrical interconnect (e.g., Figure 1) are also feasible. The electrodes 125 may, in other examples, not be connected to terminal lands 125t exposed at the insulator 130 but, e.g., to vias which may directly connect to integrated circuitry (not shown) in the substrate 120, for example.

Figure 3 illustrates a device 300 for controlling trapped ions which is implemented as a 3D ion trap. 3D ion trap geometries such as, e.g., linear Paul traps distinguish over the 2D trap geometries (see Figures 1 and 2, for example) by allowing substantially higher potential depths and higher trap frequencies. In the exemplary device 300 shown in Figure 3, the ion 180 is trapped between the substrate 120 and a further substrate 150 disposed over and spaced apart from the substrate 120. One or a plurality of spacer members 160 may be disposed between the substrate 120 and the further substrate 150.

The spacer members 160 define the spacing between the substrate 120 and the further substrate 150. The spacer members 160 may be bonded to the substrate 120 (e.g., via layers 125 and/or 130 formed thereon) and/or to the further substrate 150 (e.g., via layer 155, see below) by wafer-bonding techniques. For example, glass-bonding techniques or eutectic bonding techniques or anodic bonding techniques or thermocompression bonding techniques may be used.

A structured top electrode layer M4 may be disposed at a main side of the further substrate 150 opposite the structured electrode layer M3. The structured top electrode layer M4 forms electrodes 155 of the 3D ion trap. The 3D ion trap is configured to trap ion(s) 180 in the space between the structured electrode layer M3 and the structured top electrode layer M4.

Similar as the electrode layer M3, the top electrode layer M4 may also be formed and structured by micro-fabrication techniques. Generally, micro-fabrication techniques for electrode 125, 155 formation and structuring may, e.g., involve photolithography methods (e.g., including photoresist application, patterning, etching) and/or deposition techniques (e.g., chemical vapor deposition (CVD), physical vapor deposition (PVD), sputtering) and/or plating techniques (e.g., electroless plating, galvanic plating). Further, micro-fabrication techniques for structuring may include etching processes for structuring photoresist layers, insulator or dielectric layers 130, 140, metal layers M1, M2 and electrode layers M3, M4.

The second substrate 150, the electrode 155 and intermediate layers (not shown) may be designed as described in connection with the first substrate 120, the electrode 125 and intermediate layers (in particular, the isolator 130). Reference is made to the corresponding description for sake of brevity.

The electrodes 125, 155 formed in the structured electrode layer M3 and/or the structured top electrode layer M4 may be structured with micrometer or sub-micrometer scale precision and alignment accuracy. This allows to achieve complex electrode layouts without loss of controllability of the trapped ions 180. Further, this allows to achieve small structural widths of electrodes 125, 155 and/or feed lines for electrodes.

The electrical insulator 130 (i.e., the insulating layer between the electrode 125 and the metal layer 135) may be laterally recessed. The lateral recess in the electrical insulator 130 may be formed by etching, particularly chemical wet etching, under the structured electrode layer M3. A reason for laterally recessing the electrical insulator 130 is to reduce or avoid interference of the ions 180 caused by uncontrolled stray fields. By recessing the electrical insulator 130, possible charge carriers in or on the electrical insulator 130 are thus shielded by the overhanging electrode 125. Moreover, partly removal of the electrical insulator 130 may be beneficial to reduce coupling capacitances between RF- and DC-lines, to minimize cross-talk, dielectric losses and ohmic losses from capacitive charging currents.

Differently put, by recessing the insulator 130 the trapped ion(s) 180 are effectively prevented from "seeing" much or any surface of the insulator 130. Rather, the trapped ion(s) 180 are mainly or only seeing the structured electrode layer 125 and (optionally) the metal layer 135 (M2). Any dielectric wall surfaces of the structured insulator layer 130 may be hidden behind the overhanging portions of the electrodes 125.

Overhanging portions of electrodes 125 are sensitive to mechanical loading. They may be bent by mechanical forces. Further, electrodes 125 and/or feed lines in the structured electrode layer M3 may have small lateral dimensions. Approximately, the required lateral dimensions of electrodes 125 correspond to the height of the ion 180 in the ion trap. Generally speaking, the closer the ion 180 is trapped with regard to the structured electrode layer M3, the smaller the corresponding electrode structures should be. Once the lateral dimension of the electrode 125 approaches the required overhang length, the electrode 125 becomes mechanically unstable or even detaches.

Adding to this problem is the fact that an increased etching rate occurs at the interface between the electrode 125 and the electrical insulator 130, since fewer covalent bonds are present there. This causes the formation of an under-etch notch adjacent the underside of the electrode 125. This may impair the stability of the electrode 125 (or any other small structures in the structured electrode layer M3), since the electrode 125 then may have too little support area.

Figures 4A and 4B schematically illustrate a sectional view through a layer stack including a single electrode 125 disposed over the electrical insulator 130 and the underlying metal layers 135 (M2), 145 (M1) with the dielectric layer 140 in between. In this comparative example, the electrical insulator 130 is made of the same material as the dielectric layer 140, e.g. of silicon oxide.

In order to obtain an overhanging electrode 125, the layer stack of Figure 4A is subjected to isotropic etching (arrow IE) to laterally recess the electrical insulator 130. As shown in Figure 4B, isotropic etching causes under-etching of the electrode 125. The isotropic under-etching process IE is to ensure that the electrical insulator 130 is retracted by a target distance L_{U} measured at the bottom of the electrical insulator 130 in a lateral direction relative to the outline of the electrode 125. The target distance L_{U} may be set to be equal to or greater than the thickness D of the insulator layer 130 so that charges in or on the insulator layer 130 are efficiently shielded.

However, due to a higher etching rate at the electrode/insulator interface 125/130, the electrode 125 may become largely or completely under-etched and thus mechanically unstable (Figure 4B). In other words, even if the target distance L_{U} is significantly smaller than half the lateral electrode dimension, the (actual) under-etch distance X_{U} measured at the underside of the electrode 125 may reach half the lateral electrode dimension, i.e., the critical electrode lift off distance.

As mentioned earlier, the smaller the lateral dimension of the electrode 125 (or other structures of the structured electrode layer M3), the more critical is the electrode stability or lift-off problem (see Figure 4B). The lateral dimensions of electrodes 125 considered herein may, e.g., be less than 10 × D, or, in particular less than 5 × D.

Figure 5 is a schematic cross-sectional view of a layer stack of a device 100 in accordance with the disclosure. The layer stack includes the substrate 120, the metal layer 135 disposed over the substrate 120, the electrode 125, and an electrical insulator 130 disposed between the metal layer 135 and the electrode 120.

The electrical insulator 130 includes an upper surface 130A facing towards the electrode 125 and a lower surface 130B facing towards the metal layer 135. An etching rate of the electrical insulator 130 increases along a direction pointing from the upper surface 130A to the lower surface 130B.

Reducing the etching rate of the electrical insulator 130 towards the electrode 125 may protect the interface between the electrode 125 and the insulator 130 from excessive undercutting during isotropic etching (IE). Consequently, the area on the upper surface 130A of the insulator 130 for supporting the electrode 125 can be maintained larger. As a result, the stability of an electrode 125 of a given size on the etched insulator 130 is improved for a given target distance L_{U} compared to the comparative example shown in Figures 4A and 4B. On the other hand, electrodes 125 of smaller size can be made possible.

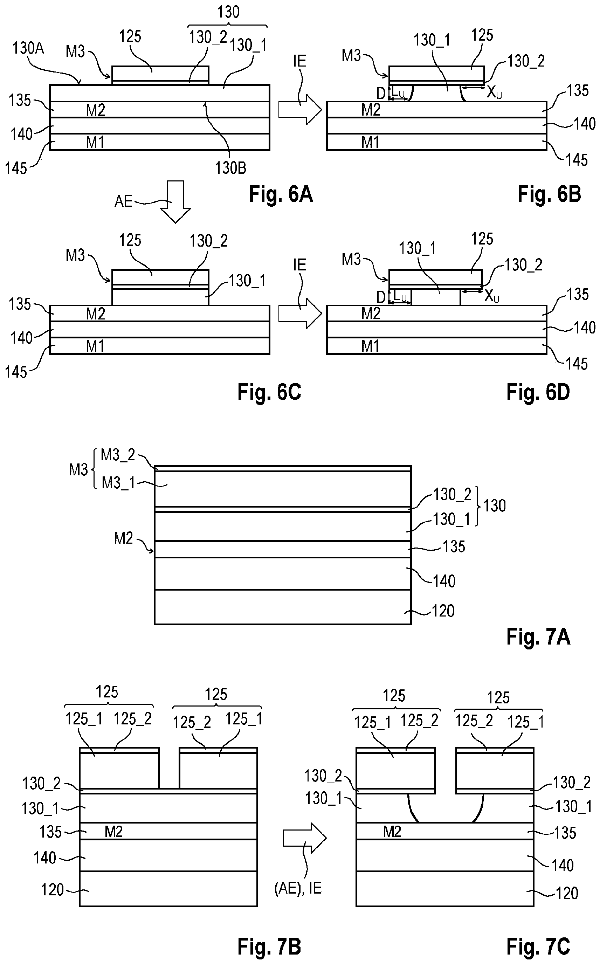

Referring to Figures 6A to 6D, in some examples the electrical insulator 130 may include a dielectric layer 130_1 and an interface layer 130_2. The interface layer 130_2 is disposed between the electrode 125 and the dielectric layer 130_1, and the dielectric layer 130_1 is disposed between the interface layer 130_2 and the metal layer 135 (M2). For example, an upper surface of the interface layer 130_2 may be in direct contact with a lower surface of the electrode 125. A lower surface of the interface layer 130_2 may, e.g., be in direct contact with an upper surface of the dielectric layer 130_1.

Except the partitioning of the electrical insulator 130 into (at least) the dielectric layer 130_1 and the interface layer 130_2, the layer stack shown in Figure 6A may include the same layers and layer dimensions as described in conjunction with Figure 4A, and reference is made to the above description to avoid reiteration.

Figures 6A and 6B are schematic cross-sectional views before and after isotropic back-etching (arrow IE) the electrical insulator 130.

The interface layer 130_2 includes or is of a first material with a first etching rate, wherein the dielectric layer 130_1 includes or is of a second material with a second etching rate. The first etching rate is smaller than the second etching rate to ensure that the etching rate of the electrical insulator 130 increases along the direction pointing from the upper surface 130A to the lower surface 130B. The etching rate referred to may, e.g., be the etching rate for isotropic etching, e.g. isotropic wet etching.

The first material (of the interface layer 130_2) is different from the second material (of the dielectric layer 130_1). The first material may be selected from the group consisting of silicon nitride, silicon oxynitride and amorphous silicon. These materials exhibit an etching rate (e.g., in HF) which is smaller than the etching rate of the second material. For example, the second material may be silicon oxide, in particular silicon oxide produced by thermal decomposition of tetraethyl orthosilicate (TEOS).

The electrical insulator 130 may be laterally recessed by isotropic etching so as to be retracted by the given target distance L_{U}. As mentioned earlier, L_{U} > D may be set to achieve a high degree of shielding.

As a result, an edge portion of length X_{U} of the electrode 125 protrudes over (i.e., overhangs) the recess (here, the under-etch distance X_{U} is measured at the level of the upper surface of the dielectric layer 130_1). Due to the smaller etching rate of the material of the interface layer 130_2 than the etching rate of the material of the dielectric layer 130_1, the insulator/electrode interface 130_2/125 is "protected" by the interface layer 130_2 against excessive undercut. In addition, the insulator-internal interface between the dielectric layer 130_1 and the interface layer 130_2 is more resistant to undercutting than an interface between the dielectric layer 130_1 and the electrode 125 would be (see, for example, the comparative example in Figures 4A and 4B). Therefore, the under-etch distance X_{U} is substantially smaller than in the comparative example of Figure 4B, where the insulator 130 may be of a single material (e.g., the material of the dielectric layer 130_1) having a constant etching rate.

In other words, the interface layer 130_2 may serve to passivate the electrode/insulator interface 125/130. On the one hand, an increased etching rate at the upper surface of the dielectric layer 130_1 (e.g., silicon oxide layer) can be prevented, thus obtaining a largely uniform undercut with significantly reduced overhang of the electrodes 125 (see Figure 6B). On the other hand, the interface layer 130_2 may reinforce the stiffness of the electrode 125, particularly in the overhang regions. This improves the electrode stability and reduces the risk of electrode damage or bending in particular in the overhang regions.

That way, the difference between the target distance L_{U} and the (actual) under-etch distance X_{U} at or in proximity of the electrode 125 can be reduced. A more homogeneous or uniform undercutting of the electrode 125 can be achieved. This helps to preserve more support area for the electrode (or any other tiny structure in the structured electrode layer M3) and, optionally, to obtain additional stiffness for the electrode 125 (if the interface layer 130_2 is resistant to isotropic etching, see Figure 6B). For example, the overhanging portion of the electrode 125 may have a length X_{U} in the range of 1 or 2 µm to about 10 um.

While Figure 6B schematically illustrates the result of isotropic under-etching (arrow IE) of the electrode 125, it is also possible to perform anisotropic etching (arrow AE) before performing the isotropic under-etching (arrow IE) of the electrical insulator 130. In such a multi-step etching process as illustrated in Figures 6C (showing the layer stack after anisotropic etching AE) and 6D (showing the layer stack after subsequent isotropic etching IE), the under-etch distance X_{U} can be further reduced for a given target distance L_{U}. That is, an additional anisotropic etching step AE may further optimize the etching profile (i.e., the shape of the lateral edge of the insulator).

Anisotropic etching (arrow AE) may be, for example, a dry etching process, e.g., plasma etching. Isotropic under-etching (arrow IE) may be a wet etching process, for example HF etching.

Figures 7A to 7C are schematic cross-sectional partial views illustrating a layer stack of an exemplary device 100, 300 for controlling trapped ions and exemplary stages of a method of manufacturing the same.

For example, the layer stack shown in Figure 7A includes a substrate 120 of, e.g., Si. The dielectric layer 140 is deposited over the substrate 120. For example, the dielectric layer 140 is implemented by a TEOS layer. The dielectric layer 140 may have a thickness of about 2.2 um, for example.

The metal layer 135 (M2) is formed (e.g., deposited) over the dielectric layer 140. For example, the metal layer 135 (M2) may be an AlSiCu layer. The metal layer 135 (M2) may, e.g., have a thickness of about 1 um.

Optionally, the metal layer 135 (M2) may then be structured to form an electrical redistribution layer (e.g., an electrode wiring layer).

The electrical insulator 130 is deposited over the metal layer 135 (M2). The electrical insulator 130 includes, for example, the dielectric layer 130_1 which is, e.g., formed by a TEOS layer.

In this example, the dielectric layer 130_1 may have a thickness of 2.2 um. Generally, the thickness of the dielectric layer 130_1 0 may be in a range between 100 nm and 10 um. If the electrode 125 is a DC electrode, a smaller dielectric layer thickness may be sufficient, while for RF electrodes (and high voltages) a dielectric layer thickness of more than 1, 2 or 4 um may be preferred.

The electrical insulator 130 may further include the interface layer 130_2, which is deposited over the dielectric layer 130_1. In this specific example, the interface layer 130_2 may, e.g., be of silicon nitride. The interface layer 130_2 may, e.g., have a thickness which is substantially (e.g., more than ten times) smaller than the thickness of the dielectric layer 130_1. The thickness of the interface layer 130_2 may, e.g., be in a range between about 50 and 150 nm. Generally speaking, the thinner the interface layer 130_2, the better is its structuring behavior. For example, the thickness of the interface layer 130_2 may be about 50 nm.

The electrode layer M3 is then formed. The electrode layer M3 may include an electrode metal layer M3_1. For example, the electrode metal layer M3_1 may have a thickness of equal to or more than 1, 1.5 or 2 um, for example. In the example shown, the electrode metal layer M3_1 is, e.g., an AlSiCu layer of 2 um thickness.

Optionally, the electrode layer M3 may, e.g., further include an electrode surface layer M3_2. For example, the electrode surface layer M3_2 may be a TiW or TiN layer which is deposited over the electrode metal layer M3_1. The electrode surface layer M3_2 may, e.g., have a thickness which is substantially (e.g., more than ten times) smaller than the thickness of the electrode metal layer M3_1. The electrode surface layer M3_2 may, e.g., have a thickness of 150 nm or less (in the example shown, the thickness of the electrode surface layer M3_2 is 50 nm, for example).

Referring to Figure 7B, the electrode layer M3 may then be patterned. Patterning of the electrode layer M3 produces the electrodes 125 and, optionally, other structures of the structured electrode layer M3. Each electrode 125 may thus include an electrode surface layer 125_2 and an electrode metal layer 125_1. The electrical insulator 130, in particular the interface layer 130_2, may serve as an etch stop for structuring the electrode layer M3.

Referring to Figure 7C, the electrical insulator 130 may then be etched. The electrode surface layer 125_2 may be used as a hard mask for, e.g., plasma etching to open the interface layer 130_2 (e.g., silicon nitride layer) and to anisotropically etch (AE) the dielectric layer 130_1 in alignment with the trenches between the electrodes 125 (see also Figure 6C). The thinner the interface layer 130_2, the easier the etching of the interface layer 130_2 can be.

Referring to Figure 7C, wet chemical isotropic etching (IE) may then be carried out to uniformly under-etch the electrodes 125 (and, optionally, other structures) of the structured electrode layer M3. As mentioned earlier (Figures 6A to 6B), the anisotropic etching (AE) can be skipped, i.e., the etching process (Figure 7B to Figure 7C) can include only isotropic etching (IE), for example.

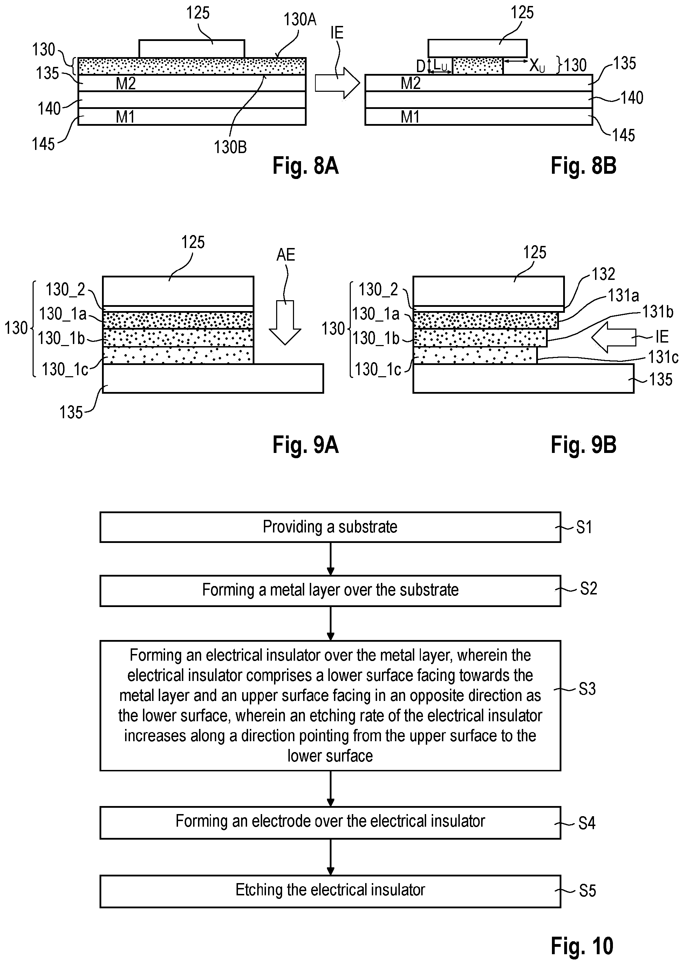

Referring to Figures 8A and 8B, in some examples, the electrical insulator 130 may have an etching rate gradient along the direction of layer thickness. For example, the etching rate gradient may be caused by a concentration gradient of materials causing different etching rates.

In some examples, the electrical insulator 130 comprises a first material and a second material, wherein a concentration of the first material at or in proximity to the upper surface 130A of the insulator 130 is greater than a concentration of the first material at or in proximity to the lower surface 130B of the insulator 130. A concentration of the second material at or in proximity to the upper surface 130A is smaller than a concentration of the second material at or in proximity to the lower surface 130B. As in the examples above, the first material is different from the second material. The first material may be selected from the group consisting of silicon nitride, silicon oxynitride and amorphous silicon. The second material may, e.g., include or be silicon oxide.

In some examples, the etching rate gradient may be caused by a plurality of sublayers having different etching rates (as will be described in more detail in connection with Figures 9A, 9B). For example, the electrical insulator 130 may include sublayers of silicon oxynitride (SiOₓN_{y}), wherein the sublayers have different concentrations y of nitride.

In some examples, an electrical insulator 130 having a continuous etching rate gradient along its thickness direction is provided. For example, the concentration of nitride in an oxynitride layer forming part of the electrical insulator 130 (e.g., representing the dielectric layer 130_1) may continuously change along the thickness direction of the electrical insulator 130.

Such continuously or stepwise changing etching rate gradient can be implemented by (continuously or stepwise) adjusting the nitride concentration of oxynitride during deposition.

Figures 8A and 8B illustrate an example in which the electrical insulator 130 is designed to have a continuous etching rate gradient along its thickness. For example, if oxynitride is used in the electrical insulator 130, the nitride concentration may be increased and the oxide concentration may be decreased during deposition. As a result an increased under-etch at the underside of the electrode 125 (i.e. at the electrode/insulator interface 125/130) may be prevented. Figure 8B schematically illustrates the result after performing the isotropic (wet) under-etch (IE) of the electrode 125 until, e.g., L_{U} > D. Here, the under-etch distance X_{U} at the underside of the electrode 125 (or, as depicted in Figure 6D, at the underside of an etchresistant interface layer 130_2, if existing) may be approximately equal to the target distance L_{U} along the entire vertical extension of the edge of the electrical insulator 130.

Figures 9A is a schematic cross-sectional partial view of an electrode 125 (after anisotropic etching - arrow AE) disposed over an electrical insulator 130 having a stepwise changing etch gradient. More specifically, the electrical insulator 130 may include the (optional) interface layer 130_2 and the dielectric layer 130_1, which is includes separate sublayers 130_1a, 130_1b, 130_1c, .... Each of these sublayers 130_1a, 130_1b, 130_1c may have slightly different deposition parameters to vary the etching rate in the isotropic wet etch chemistry (Figure 9B, arrow IE).

Differently stated, the sublayer stack includes several sublayers 130_1a, 130_1b, 130_1c with different etching rates. This can be achieved, for example, by using silicon oxynitride with different nitride concentrations per sublayer 130_1a, 130_1b, 130_1c.

Thus, according to one aspect of the disclosure, the electrical insulator 130 may include a layer of silicon oxynitride, wherein a composition of the silicon oxynitride changes continuously and/or stepwise in the direction pointing from the upper surface 130A to the lower surface 130B of the electrical insulator 130 (Figures 5, 8B, 9B). For example, the nitride concentration may decrease in the direction pointing from the upper surface 130A to the lower surface 130B while the oxide concentration may increase along this direction.

The electrical insulator 130 may have a stepped lateral edge after isotropic etching, see, e.g., Figure 9B. For example, the (optional) interface layer 130_2 and the sublayers 130_1a, 130_1b, 130_1c define lateral edges 132, 131a, 131b, 131c, respectively. A lateral edge of a higher sublayer may laterally protrude over a lateral edge of a lower sublayer, for example. This "inverted" lateral edge (as compared with the comparative example of Figure 4B) may further increases stability of the electrode 125.

According to one aspect of the disclosure, the electrical insulator 130 may provide a first lateral edge at a first level and a second lateral edge at a second level, the second lateral edge is located above the first lateral edge in a direction pointing from the lower surface 130B to the upper surface 130A, wherein the second lateral edge protrudes over the first lateral edge in the lateral direction. For example, referring to Figure 9B, the first lateral edge may be lateral edge 131c at the level of the sublayer 130_1c, and the second lateral edge may be lateral edge 131a at the level of sublayer of 130_1a. Since the higher sublayers (e.g., 130_1a, 130_1b) are geometrically better shielded from the "view" of the ion 180 than lower sublayers (e.g., 130_1c), this "inverted" lateral edge may not reduce the shielding capacity of the device.

If the electrical insulator 130 has a continuous etching rate gradient along its thickness direction rather than an etching gradient sublayer structure, the lateral edge of the electrical insulator 130 may not be stepped but, e.g., continuously inclined.

In both cases, the electrical insulator 130 may have a tapering shape in the direction from the upper surface 130A to the lower surface 130B.

Figure 10 is a flowchart illustrating exemplary stages of a method of manufacturing a device for controlling trapped ions.

At S1, a substrate is provided.

At S2, a metal layer is formed over the substrate.

At S3, an electrical insulator is formed over the metal layer, wherein the electrical insulator comprises a lower surface facing towards the metal layer and an upper surface facing in an opposite direction as the lower surface, wherein an etching rate of the electrical insulator increases along a direction pointing from the upper surface to lower surface. Alternatively or within this process, an interface layer (for protecting an interface between the electrical insulator and the electrode (see S4)) may be formed.

At S4, the electrode is formed over the electrical insulator. Forming the electrode may comprise electrode layer deposition and structuring, for example.

At S5, the electrical insulator is etched. The structured electrode layer may be used as an etching mask. Etching may include (optional) anisotropic etching of the electrical insulator (which may, at that time, be an unstructured insulator layer) in alignment with the electrode and isotropic etching for recessing the electrical insulator in the lateral direction (i.e., to produce the overhang region of the electrode). By isotropic etching, a desired shape of the lateral edge of the electrical insulator may be provided with the aim to increase electrode stability and preserve shielding efficiency. This may be achieved by an etching gradient material included in the electrical insulator and/or by the inclusion of an interface layer in the electrical insulator forming the upper surface thereof, for example.

### EXAMPLES

The following examples pertain to further aspects of the disclosure:
Example 1 is a device for controlling trapped ions comprising a substrate. A metal layer is disposed over the substrate. An electrode of an ion trap is disposed over the metal layer, wherein the electrode is configured to trap one or more ions in a space above the electrode. An electrical insulator is disposed between the metal layer and the electrode. The electrical insulator comprises an upper surface facing towards the electrode and a lower surface facing towards the metal layer. An etching rate of the electrical insulator increases along a direction pointing from the upper surface to the lower surface.
In Example 2, the subject matter of Example 1 can optionally include wherein the electrical insulator comprises a dielectric layer and an interface layer, wherein the interface layer is disposed between the electrode and the dielectric layer, wherein the dielectric layer is disposed between the interface layer and the metal layer, wherein the interface layer comprises a first material with a first etching rate, wherein the dielectric layer comprises a second material with a second etching rate, and wherein the first etching rate is smaller than the second etching rate.
In Example 3, the subject matter of Example 1 can optionally include wherein the electrical insulator comprises a first material and a second material, wherein a concentration of the first material at or in proximity to the upper surface is greater than a concentration of the first material at or in proximity to the lower surface, and wherein a concentration of the second material at or in proximity to the upper surface is smaller than a concentration of the second material at or in proximity to the lower surface.
In Example 4, the subject matter of Example 2 or 3 can optionally include wherein the first material is selected from the group consisting of silicon nitride, silicon oxynitride and amorphous silicon, and wherein the second material is a dielectric material different from the first material.
In Example 5, the subject matter of any of the preceding Examples can optionally include wherein the electrical insulator provides a first lateral edge at a first level and a second lateral edge at a second level, the second level is located above the first level in a direction pointing from the lower surface to the upper surface, wherein the second lateral edge protrudes over the first lateral edge in a lateral direction.
In Example 6, the subject matter of Example 5 can optionally include wherein the electrical insulator has a tapering shape in the direction pointing from the upper surface to the lower surface.
In Example 7, the subject matter of Example 2 can optionally include wherein the interface layer has a thickness equal to or less than 150 nm.
In Example 8, the subject matter of any of Example 2 or 7 can optionally include wherein the dielectric layer comprises a plurality of sublayers of silicon oxynitride, wherein the sublayers have different concentrations of nitride.
In Example 9, the subject matter of any of Examples 2 to 4 can optionally include wherein the second material is silicon oxide.
In Example 10, the subject matter of Example 2 or 7 or 8 can optionally include wherein an upper surface of the interface layer directly contacts to a lower surface of the electrode.
In Example 11, the subject matter of Example 2 or 7 or 8 or 10 can optionally further include wherein a lower surface of the interface layer directly contacts to an upper surface of the dielectric layer.
In Example 12, the subject matter of any of the preceding Examples can optionally include wherein a lateral dimension of the electrode is less than 10 × D, wherein D is the thickness of the electrical insulator.
In Example 13, the subject matter of any of the preceding Examples can optionally further include an electrode feed line connected to the electrode, wherein the electrode feed line and the electrode are part of a structured electrode layer.
Example 14 is method of manufacturing a device for controlling trapped ions, the method comprising providing a substrate; forming a metal layer over the substrate; forming an electrical insulator over the metal layer, wherein the electrical insulator comprises a lower surface facing towards the metal layer and an upper surface facing in an opposite direction as the lower surface, wherein an etching rate of the electrical insulator increases along a direction pointing from the upper surface to the lower surface; forming the electrode over the electrical insulator; and etching the electrical insulator.
In Example 15, the subject matter of Example 14 can optionally further include wherein forming the electrical insulator comprises forming a dielectric layer and an interface layer, wherein the interface layer is disposed between the electrode and the dielectric layer, wherein the dielectric layer is disposed between the interface layer and the metal layer, wherein the interface layer comprises a first material with a first etching rate, wherein the dielectric layer comprises a second material with a second etching rate, and wherein the first etching rate is smaller than the second etching rate.
In Example 16, the subject matter of Example 14 can optionally further include wherein the electrical insulator comprises a first material and a second material, wherein a concentration of the first material at or in proximity to the upper surface is greater than a concentration of the first material at or in proximity to the lower surface, and wherein a concentration of the second material at or in proximity to the upper surface is smaller than a concentration of the second material at or in proximity to the lower surface.
In Example 17, the subject matter of Example 15 can optionally further include structuring the interface layer in alignment with the electrode before etching the dielectric layer.
In Example 18, the subject matter of Example 15 can optionally further include structuring the interface layer during etching the dielectric layer.
In Example 19, the subject matter of any of Examples 14 to 18 can optionally further include wherein etching the electrical insulator comprises performing isotropic etching.
In Example 20, the subject matter of Example 19 can optionally further include performing anisotropic etching before performing isotropic etching.
Example 21 is a device for controlling trapped ions comprising a substrate. A metal layer is disposed over the substrate. An electrode of an ion trap is disposed over the metal layer, wherein the electrode is configured to trap one or more ions in a space above the electrode. An electrical insulator is disposed between the metal layer and the electrode. The electrical insulator comprises a dielectric layer and an interface layer disposed between the dielectric layer and the electrode. The interface layer comprises or is of a material which is different from the material of the dielectric layer and is selected from the group consisting silicon oxide, silicon oxynitride and amorphous silicon.
Example 22 is a device for controlling trapped ions which comprises a substrate. A metal layer is disposed over the substrate. An electrode of an ion trap is disposed over the metal layer, wherein the electrode is configured to trap one or more ions in a space above the electrode. An electrical insulator is disposed between the metal layer and the electrode. The electrical insulator comprises an upper surface facing towards the electrode and a lower surface facing towards the metal layer. The electrical insulator provides a first lateral edge at a first level and a second lateral edge at a second level, the second lateral edge is located above the first lateral edge in a direction pointing from the lower surface to the upper surface, wherein the second lateral edge protrudes over the first lateral edge in the lateral direction.
Example 23 is a device for controlling trapped ions which comprises a substrate. A metal layer is disposed over the substrate. An electrode of an ion trap is disposed over the metal layer, wherein the electrode is configured to trap one or more ions in a space above the electrode. An electrical insulator is disposed between the metal layer and the electrode. The electrical insulator comprises an upper surface facing towards the electrode and a lower surface facing towards the metal layer. The electrical insulator 130 comprises a layer of silicon oxynitride, wherein a composition of the silicon oxynitride changes continuously and/or stepwise in the direction pointing from the upper surface to the lower surface of the electrical insulator.
Although specific examples have been illustrated and described herein, it will be appreciated by those of ordinary skill in the art that a variety of alternate and/or equivalent implementations may be substituted for the specific examples shown and described without departing from the scope of the present invention. This application is intended to cover any adaptations or variations of the specific examples discussed herein. Therefore, it is intended that this invention be limited only by the claims and the equivalents thereof.

## Claims

1. A device for controlling trapped ions, the device comprising:
a substrate;
a metal layer disposed over the substrate;
an electrode of an ion trap disposed over the metal layer, wherein the electrode is configured to trap one or more ions in a space above the electrode; and
an electrical insulator disposed between the metal layer and the electrode, wherein
the electrical insulator comprises an upper surface facing towards the electrode and a lower surface facing towards the metal layer, wherein
an etching rate of the electrical insulator increases along a direction pointing from the upper surface to the lower surface.

2. The device of claim 1, wherein
the electrical insulator comprises a dielectric layer and an interface layer, wherein
the interface layer is disposed between the electrode and the dielectric layer, wherein
the dielectric layer is disposed between the interface layer and the metal layer, wherein
the interface layer comprises a first material with a first etching rate, wherein
the dielectric layer comprises a second material with a second etching rate, and wherein
the first etching rate is smaller than the second etching rate.

3. The device of claim 1, wherein
the electrical insulator comprises a first material and a second material, wherein
a concentration of the first material at or in proximity to the upper surface is greater than a concentration of the first material at or in proximity to the lower surface, and wherein
a concentration of the second material at or in proximity to the upper surface is smaller than a concentration of the second material at or in proximity to the lower surface.

4. The device of claim 2 or 3, wherein
the first material is selected from the group consisting of silicon nitride, silicon oxynitride and amorphous silicon, and wherein
the second material is a dielectric material different from the first material.

5. The device of any of the preceding claims, wherein
the electrical insulator provides a first lateral edge at a first level and a second lateral edge at a second level,
the second level is located above the first level in a direction pointing from the lower surface to the upper surface, wherein
the second lateral edge protrudes over the first lateral edge in a lateral direction.

6. The device of claim 5, wherein
the electrical insulator has a tapering shape in the direction pointing from the upper surface to the lower surface.

7. The device of claim 2, wherein
the interface layer has a thickness equal to or less than 150 nm.

8. The device of claim 2 or 7,
wherein the dielectric layer comprises silicon oxynitride, wherein a nitride concentration of the dielectric layer decreases in the direction pointing from the upper surface to the lower surface, and wherein an oxide concentration of the dielectric layer increases in the direction pointing from the upper surface to the lower surface; and/or
wherein the dielectric layer comprises a plurality of sublayers of silicon oxynitride, wherein the sublayers have different concentrations of nitride.

9. The device of any of claims 2 to 4, wherein
the second material is silicon oxide.

10. The device of any of claims 2 or 7 or 8, wherein
an upper surface of the interface layer directly contacts to a lower surface of the electrode; and/or
wherein
a lower surface of the interface layer directly contacts to an upper surface of the dielectric layer.

11. The device of any of any of the preceding claims, wherein
a lateral dimension of the electrode is less than 10 × D, wherein D is the thickness of the electrical insulator.

12. The device of any of the preceding claims further comprising:
an electrode feed line connected to the electrode, wherein the electrode feed line and the electrode are part of a structured electrode layer.

13. A method of manufacturing a device for controlling trapped ions, the method comprising:
providing a substrate;
forming a metal layer over the substrate;
forming an electrical insulator over the metal layer,
wherein the electrical insulator comprises a lower surface facing towards the metal layer and an upper surface facing in an opposite direction as the lower surface, wherein an etching rate of the electrical insulator increases along a direction pointing from the upper surface to the lower surface;
forming the electrode over the electrical insulator; and
etching the electrical insulator.

14. The method of claim 13, wherein forming the electrical insulator comprises:
forming a dielectric layer and an interface layer, wherein
the interface layer is disposed between the electrode and the dielectric layer, wherein
the dielectric layer is disposed between the interface layer and the metal layer, wherein
the interface layer comprises a first material with a first etching rate, wherein
the dielectric layer comprises a second material with a second etching rate, and wherein
the first etching rate is smaller than the second etching rate; or
wherein
the electrical insulator comprises a first material and a second material, wherein
a concentration of the first material at or in proximity to the upper surface is greater than a concentration of the first material at or in proximity to the lower surface, and wherein
a concentration of the second material at or in proximity to the upper surface is smaller than a concentration of the second material at or in proximity to the lower surface.

15. The method of claim 14, further comprising:
structuring the interface layer in alignment with the electrode before etching the dielectric layer; or
structuring the interface layer during etching the dielectric layer.

16. The method of any of claims 13 to 15, wherein etching the electrical insulator comprises:
performing isotropic etching; and/or
the method further comprising:
performing anisotropic etching before performing isotropic etching.
